# EUROPEAN PATENT SPECIFICATION

(11) **EP 4 244 412 B1**
(45) Date of publication and mention of the grant of the patent: **25.02.2026**
(21) Application number: 20821478.3
(22) Date of filing: 12.11.2020
(51) Int. Cl.: C30B 15/14, C30B 29/06

(54) **INGOT PULLER APPARATUS HAVING A HEAT SHIELD DISPOSED BELOW A SIDE HEATER AND METHODS FOR PREPARING AN INGOT WITH SUCH APPARATUS**
INGOTZIEHVORRICHTUNG MIT EINEM HITZESCHILD UNTER EINER SEITENHEIZUNG UND VERFAHREN ZUR HERSTELLUNG EINES INGOTS MIT SOLCH EINER VORRICHTUNG
APPAREIL DE TIRAGE DE LINGOT AYANT UN ÉCRAN THERMIQUE DISPOSÉ AU-DESSOUS D'UN DISPOSITIF DE CHAUFFAGE LATÉRAL ET PROCÉDÉS DE PRÉPARATION D'UN LINGOT AVEC UN TEL APPAREIL

(43) Date of publication of application: 20.09.2023
(73) Proprietor: GlobalWafers Co., Ltd., Hsinchu (TW)
(72) Inventor: BHAGAVAT, Sumeet S., St. Peters, Missouri 63376 (US); DAGGOLU, Parthiv, St. Peters, Missouri 63376 (US); MEYER, Benjamin Michael, St. Peters, Missouri 63376 (US); RYU, JaeWoo, St. Peters, Missouri 63376 (US)
(74) Representative: Maiwald GmbH
(86) International application number: PCT/US2020/060097
(87) International publication number: WO 2022/103391

(56) References cited:
- CN-A- 105 887 186
- JP-A- 2010 208 939
- JP-A- H09 202 685
- JP-A- H09 208 363
- KR-A- 20160 098 869
- US-A1- 2007 215 038
- US-A1- 2018 320 288

## Description

### FIELD OF THE DISCLOSURE

The field of the disclosure relates to ingot puller apparatus and, in particular, ingot puller apparatus having a heat shield disposed below a side heater.

### BACKGROUND

Some conventional ingot puller apparatus include a relatively long side heater in the ingot puller hotzone. To achieve a desired temperature profile in the melt, insulation is removed toward the bottom of the hotzone. Removal of insulation increases the side heater energy input thereby decreasing thermal efficiency. Further, relatively long heaters may heat the bottom of the crucible and the shaft used to raise the crucible when the crucible is raised during crystal growth further decreasing the energy efficiency of the process. CN105887186 and JP2010208939 disclose ingot puller apparatuses for producing a silicon ingot according to the state of the art.

A need exists for ingot puller apparatus having a hotzone that allows a desirable temperature profile to be achieved while increasing the efficiency of the hotzone and the heating system.

This section is intended to introduce the reader to various aspects of art that may be related to various aspects of the disclosure, which are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

### SUMMARY

One aspect of the present invention is directed to an ingot puller apparatus for producing a silicon ingot according to independent claim 1.

Yet another aspect of the present invention is directed to a method for preparing an ingot in an ingot puller apparatus according to independent claim 11**.**

Various refinements exist of the features noted in relation to the above-mentioned aspects of the present disclosure. Further features may also be incorporated in the above-mentioned aspects of the present disclosure as well. The scope of the present invention is defined as set forth in the appended claims.

### BRIEF DESCRIPTION OF THE DRAWINGS

Figure 1 is an cross-section view of an ingot puller apparatus having a heat shield disposed below a side heater with the crucible in the lowest position;
Figure 2 is a cross-section view of the ingot puller apparatus during ingot growth;
Figure 3 is a cross-section view of the ingot puller apparatus with the crucible in a terminal position in which the melt is depleted;
Figure 4 is a cross-section view of another ingot puller apparatus having a relatively longer side heater and without a heat shield disposed below the side heater (not part of the invention);
Figure 5 is a schematic view of the temperature profile of the melt and side heater of the ingot puller apparatus of Figure 4; and
Figure 6 is a schematic view of the temperature profile of the melt and side heater of the ingot puller apparatus of Figures 1-3.

Corresponding reference characters indicate corresponding parts throughout the drawings.

### DETAILED DESCRIPTION

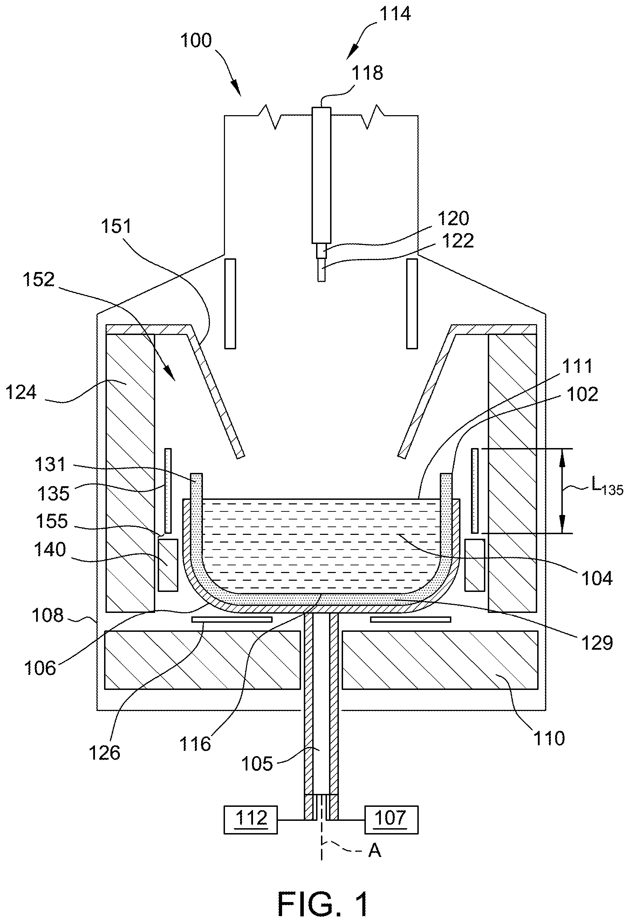

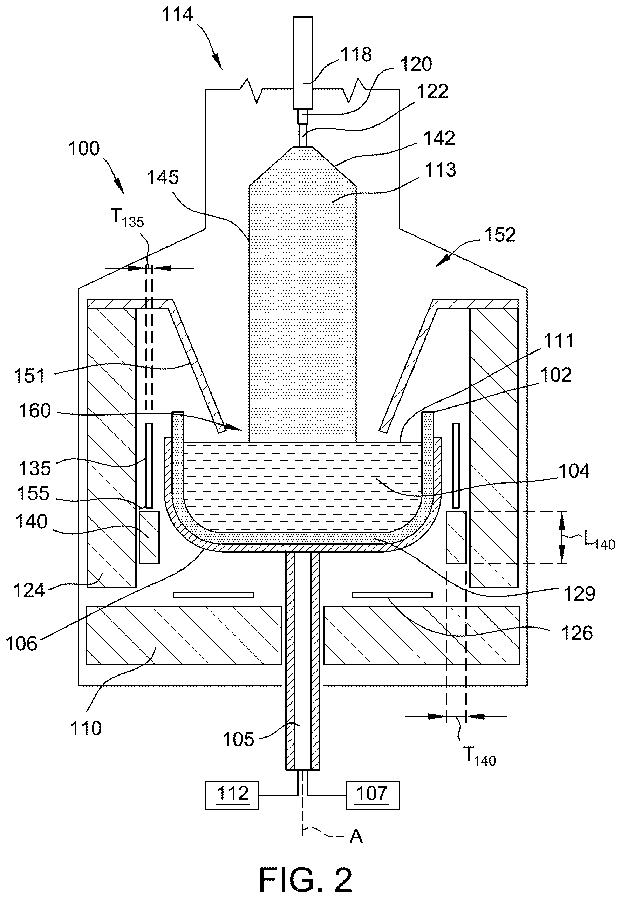

An ingot puller apparatus (or more simply "ingot puller") is indicated generally at "100" in Figure 1. The ingot puller apparatus 100 includes a crucible 102 for holding a melt 104 of semiconductor or solar-grade material, such as silicon, supported by a susceptor 106. The ingot puller apparatus 100 includes a crystal puller housing 108 that defines a growth chamber 152 for pulling a silicon ingot 113 (Fig. 2) from the melt 104 along a pull axis A.

The crucible 102 includes a floor 129 and a sidewall 131 that extends upward from the floor 129. The sidewall 131 is generally vertical. The floor 129 includes the curved portion of the crucible 102 that extends below the sidewall 131. The crucible 102 includes a bottom 116 which is the lowest point of the crucible 102 relative to the pull axis A. Within the crucible 102 is a silicon melt 104 having a melt surface 111 (i.e., melt-ingot interface).

The susceptor 106 is supported by a shaft 105. The susceptor 106, crucible 102, shaft 105 and ingot 113 (Fig. 2) have a common longitudinal axis A or "pull axis" A.

A pulling mechanism 114 is provided within the ingot puller apparatus 100 for growing and pulling an ingot 113 from the melt 104. Pulling mechanism 114 includes a pulling cable 118, a seed holder or chuck 120 coupled to one end of the pulling cable 118, and a seed crystal 122 coupled to the seed holder or chuck 120 for initiating crystal growth. One end of the pulling cable 118 is connected to a pulley (not shown) or a drum (not shown), or any other suitable type of lifting mechanism, for example, a shaft, and the other end is connected to the chuck 120 that holds the seed crystal 122. In operation, the seed crystal 122 is lowered to contact the melt 104. The pulling mechanism 114 is operated to cause the seed crystal 122 to rise. This causes a single crystal ingot 113 (Fig. 2) to be pulled from the melt 104.

During heating and crystal pulling, a crucible drive unit 107 (e.g., a motor) rotates the crucible 102 and susceptor 106. A lift mechanism 112 raises and lowers the crucible 102 along the pull axis A during the growth process. For example, as shown in Figure 1, the crucible may be at a lowest position (near the bottom heater 126) in which a charge of solid polycrystalline silicon previously added to the crucible melt 104 with the seed crystal 122 and lifting the seed crystal 122 by the pulling mechanism 114. The crucible 102 may be raised a distance from its lowest position before the melt 104 is contacted with the seed crystal 122 (i.e., raised to a "seed-dip position").

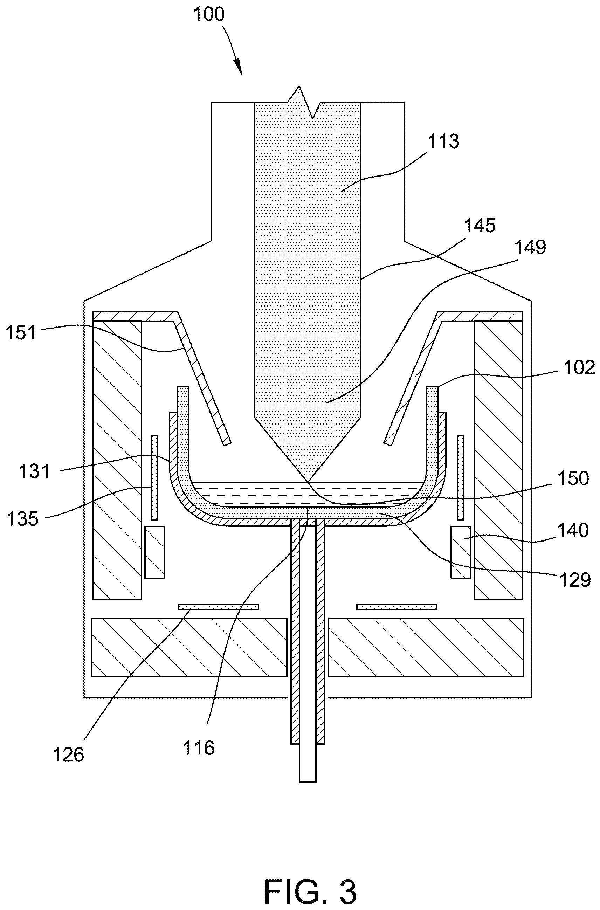

As the ingot grows, the silicon melt 104 is consumed and the height of the melt in the crucible 102 decreases. The crucible 102 and susceptor 106 may be raised to maintain the melt surface 111 at or near the same position relative to the ingot puller apparatus 100. The crucible 102 may move axially between its lowest position shown in Figure 1 (e.g., at meltdown), to the seed-dip position at which a seed crystal is initially contacted with the melt to pull the silicon ingot from the melt, and a terminal position (Fig. 3) in which the crucible has been depleted of melt. The terminal position of the crucible 102 is above the seed-dip position of the crucible 102 (and lowest position).

A crystal drive unit (not shown) may also rotate the pulling cable 118 and ingot 113 (Fig. 2) in a direction opposite the direction in which the crucible drive unit 107 rotates the crucible 102 (e.g., counter-rotation). In embodiments using iso-rotation, the crystal drive unit may rotate the pulling cable 118 in the same direction in which crucible drive unit 107 rotates the crucible 102. In addition, the crystal drive unit raises and lowers the ingot 113 relative to the melt surface 111 as desired during the growth process.

The ingot puller apparatus 100 may include an inert gas system to introduce and withdraw an inert gas such as argon from the growth chamber 152. The ingot puller apparatus 100 may also include a dopant feed system (not shown) for introducing dopant into the melt 104.

According to the Czochralski single crystal growth process, a quantity of polycrystalline silicon, or polysilicon, is charged to the crucible 102. The semiconductor or solar-grade material that is introduced into the crucible is melted by heat provided from one or more heating elements. The ingot puller apparatus 100 includes bottom insulation 110 and side insulation 124 to retain heat in the puller apparatus. In the illustrated embodiment, the ingot puller apparatus 100 includes a bottom heater 126 disposed below the crucible floor 129. The crucible 102 may be moved to be in relatively close proximity to the bottom heater 126 to melt the polycrystalline charged to the crucible 102.

To form the ingot, the seed crystal 122 is contacted with the surface 111 of the melt 104. The pulling mechanism 114 is operated to pull the seed crystal 122 from the melt 104. Referring now to Figure 2, the ingot 113 includes a crown portion 142 in which the ingot transitions and tapers outward from the seed crystal 122 to reach a target diameter. The ingot 113 includes a constant diameter portion 145 or cylindrical "main body" of the crystal which is grown by increasing the pull rate. The main body 145 of the ingot 113 has a relatively constant diameter. The ingot 113 includes a tail or end-cone 149 (Fig. 3) in which the ingot tapers in diameter after the main body 145. When the diameter becomes small enough, the ingot 113 is then separated from the melt 104. The ingot 113 has a central longitudinal axis A that extends through the crown portion 142 and a terminal end 150 of the ingot 113.

The ingot puller apparatus 100 includes a side heater 135 and a susceptor 106 that encircles the crucible 102 to maintain the temperature of the melt 104 during crystal growth. The side heater 135 is disposed radially outward to the crucible sidewall 131 as the crucible 102 travels up and down the pull axis A (e.g., from the lowest position to the terminal position). The side heater 135 and bottom heater 126 may be any type of heater that allows the side heater 135 and bottom heater 126 to operate as described herein. In some embodiments, the heaters 135, 126 are resistance heaters. The side heater 135 and bottom heater 126 may be controlled by a control system (not shown) so that the temperature of the melt 104 is controlled throughout the pulling process.

In accordance with embodiments of the present disclosure, the side heater 135 may have a relatively shorter length L₁₃₅ (i.e., height) relative to conventional ingot crystal pullers which may reduce the amount of oxygen taken up in the ingot 113. In some embodiments, the side heater 135 may have a length L₁₃₅ of 500 mm or less, 450 mm or less, 400 mm or less, or 350 mm or less. At least a portion of the side heater 135 is laterally aligned with the sidewall 131 of the crucible 102 as the crucible 102 travels between the crucible lowest position, seed-dip position and the terminal position (e.g., a radius that orthogonally extends outward from the pull axis A is capable of intersecting the sidewall 131 and crucible 102).

The ingot puller apparatus 100 also includes a heat shield 140 that encircles the crucible 102 and susceptor 106 to maintain the temperature of the melt 104 during crystal growth. The heat shield 140 is disposed below the side heater 135 and may be separated from the side heater 135 by a gap 155. In some embodiments, the heat shield 140 is separated from the side heater 135 by no more than about 50 mm or no more than 40 mm (e.g., from 30 mm to about 50 mm). In other embodiments, the heat shield 140 is not separated from the side heater 135 (i.e., the heat shield 140 and side heater 135 are continuous).

In the illustrated embodiment, the heat shield 140 is disposed directly below the side heater 135 (i.e., the side heater 135 and heat shield 140 are aligned when viewed from below or "vertically aligned"). According to the invention, the heat shield 140 has a length L₁₄₀ (Fig. 2) that is greater than the thickness T₁₄₀ of the heat shield 140. The heat shield 140 may have a thickness T₁₄₀ that is at least 1.1 times the thickness T₁₃₅ of the side heater 135, at least 1.25 times the thickness T₁₃₅ of the side heater 135, or at least 1.5 times the thickness T₁₃₅ of the side heater 135 (e.g., from 2 1.1 to 2.0 times the thickness T₁₃₅ of the side heater 135.). The heat shield 140 is radially disposed relative to the side heater 135 such that a portion of the heat shield 140 overlaps each side of the side heater 135 (i.e., when viewed from above a first portion of the heat shield 140 is radially inward to the side heater 135 and a second portion of the heat shield 140 is radially outward to the side heater 135).

The heat shield 140 may generally be made of any material that reduces cooling of the bottom portion of the side heater 135. The heat shield may include insulation or reflective material. The heat shield may be layered. In embodiments in which the heat shield is made of insulation, the insulation may be capped with graphite to reduce risk of zero dislocation in the ingot. In some embodiments, the heat shield may include a graphite shell with molybdenum sheets being disposed within the shell to block radiation.

The ingot puller apparatus 100 may include a second heat shield 151 (e.g., with the first heat shield 140 being a "lower" heat shield and the second heat shield 151 being an "upper heat shield" ). The second heat shield 151 may shroud the ingot 113 such that the ingot passes through an opening 160 formed by the heat shield 151. The heat shield 151 may be disposed within the crucible 102 during crystal growth (e.g., as shown in the terminal position of the crucible 102 as shown in Figure 3).

The crucible 102 is shown in its lowest position in Figure 1. In the illustrated embodiment, when the crucible 102 is in its lowest position, the side heater 135 is fully above the floor 129 of the crucible 102. For example, the distance between the bottom 116 of the crucible 102 and the side heater 135 (i.e., the distance to the bottom of the side heater 135) may be at least about 25 mm or at least about 50 mm. The distance between the bottom 116 of the crucible 102 and the top of the side heater 135 may be at least about 75 mm or at least about 100 mm. At least a portion of the heat shield 140 is above the bottom 116 of the crucible 102. At least a portion of the heat shield 140 is also below at least a portion of the floor 129 of the crucible 102.

The crucible 102 is shown in its terminal position in Figure 3. In the illustrated embodiment, when the crucible 102 is in the terminal position, the heat shield 140 is fully below the floor 129 of the crucible 102. The heat shield 140 is also fully below the susceptor 106 when the crucible 102 is in the terminal position.

Ingot puller apparatus of the present disclosure have several advantages over conventional ingot puller apparatus. In embodiments in which the ingot puller apparatus includes a relatively short side heater (e.g., when the side heater has a length of 500 mm or less, 450 mm or less, 400 mm or less or 350 mm or less and/or the side heater is fully above the floor of the crucible when the crucible is in its lowest position), the heat from the side heater is directed to the crucible and susceptor directly rather than some energy being directed toward the shaft and bottom insulation as the crucible is raised during ingot growth. This results in more efficient energy usage and moves the melt hotspot upward from the melt-crucible interface. This allows more insulation to be added to move the hotspot down and maintain the same temperature profile with less energy and with less leaks toward the bottom of the hotzone thereby improving efficiency. During growth of the late body of the ingot (i.e., the portion of the constant diameter portion toward the end-cone which is grown when the crucible is relatively high in the puller apparatus), the temperature range of the crucible wall may be wider relatively to use of longer heaters which allows the interstitial oxygen of the late body to be reduced.

The heat shield reduces cooling of the lower portion of the side heater because the heat shield reduces exposure to the relatively cooler components toward the bottom of the hotzone. This reduces the energy needed for the heater to achieve its desired temperature and increases the energy efficiency of the hotzone.

### EXAMPLES

The processes of the present disclosure are further illustrated by the following Examples. These Examples should not be viewed in a limiting sense.

### Example 1: Use of a Hotzone with a 525 mm Heater vs a Hotzone with a 325 mm Heater with a Heat Shield Disposed Below the Heater

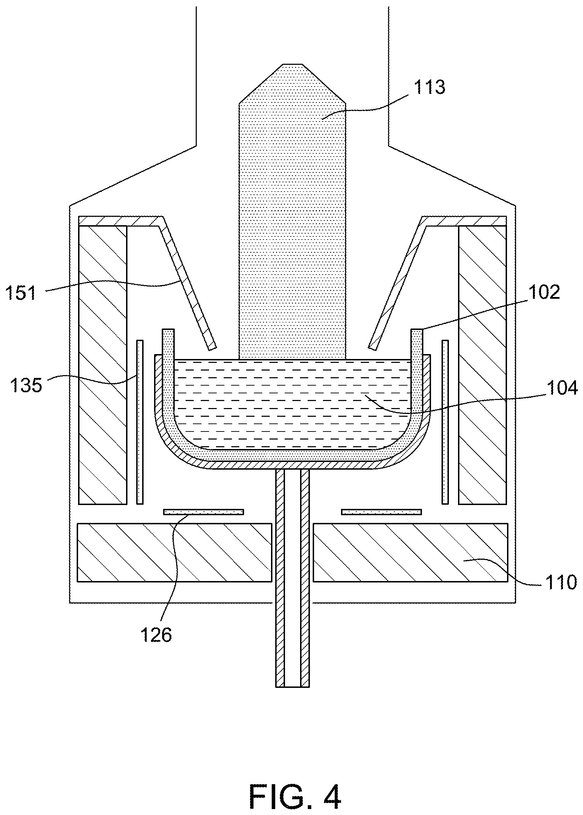

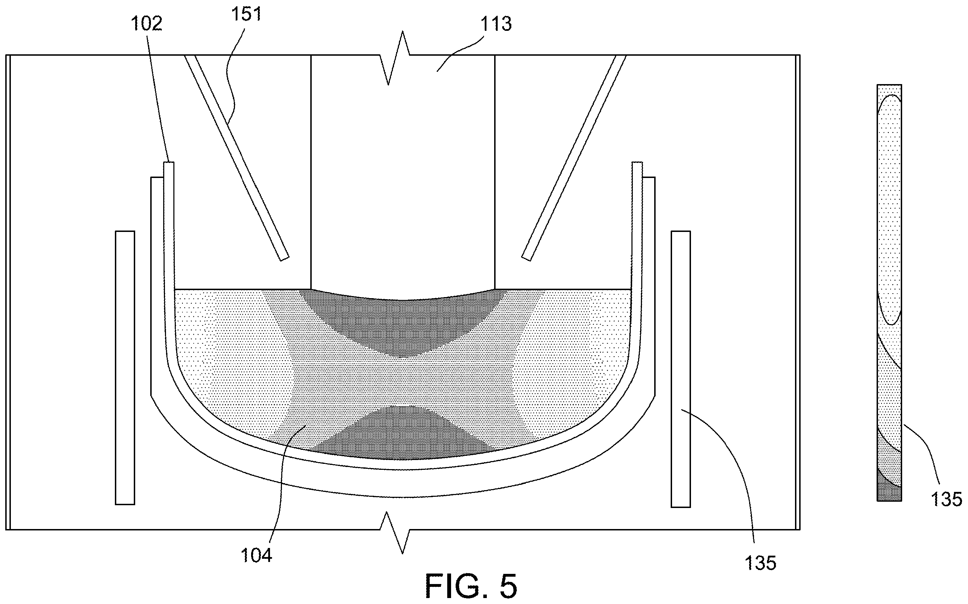

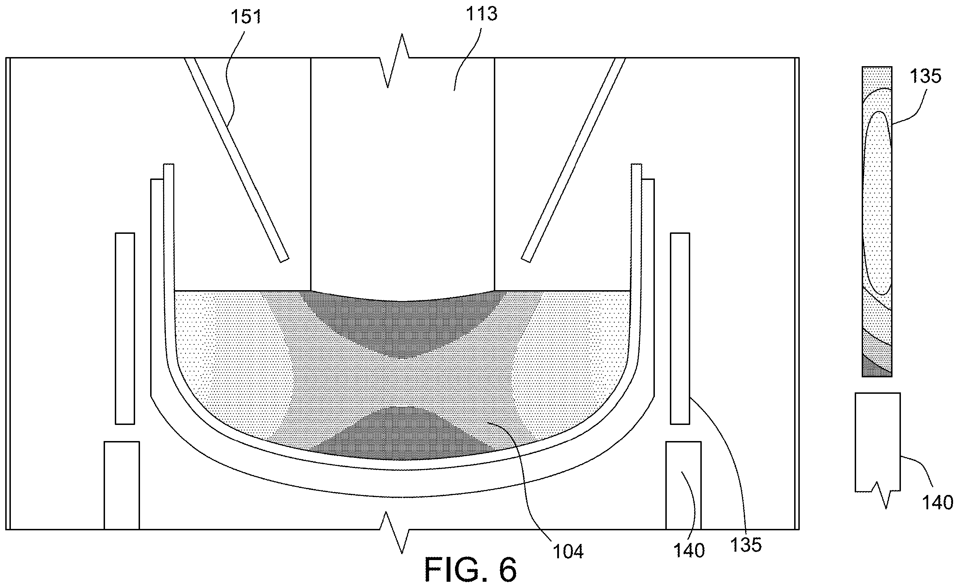

Figure 5 shows the temperature profile of the hotzone configuration of the ingot puller apparatus of Figure 4 (cooler portions of the melt and heater are shown with darker stippling in Figures 5 and 6). The hotzone of Figure 4 included a side heater 135 with a length of 525 mm and did not include a heat shield below the side heater. The hotzone also included a portion of the insulation removed toward the bottom of the hotzone to achieve the desired temperature profile. The side heater of Figure 4 was operated at 103 kW and the bottom heater was operated at 5 kW (108 kW total heat input). The temperature profile of Figure 5 is desirable as the melt hotspot is at the melt-crucible interface. As shown in the temperature profile of the side heater which is to the right of Figure 5, the side heater was relatively cool toward the lower portions of the heater because of the reduced insulation.

Figure 6 shows the temperature profile of the hotzone configuration of the ingot puller apparatus of Figures 1-3 in which a relatively shorter side heater 135 of 325 mm in length was used (i.e., 200 mm less than the side heater of Figure 4). The hotzone included a heat shield 140 disposed below the side heater 135. The hotzone included an amount of insulation (about 1 inch) removed toward the bottom of the ingot puller apparatus relative to the hotzone of Figure 4. The side heater 135 was operated at 59 kW and the bottom heater was operated at 5 kW (64 kW total heat input).

As shown in Figure 6, the melt had substantially the same desirable temperature profile as the hotzone of Figure 4 (which is shown in Figure 5) but the ingot puller apparatus was operated with 44 kW less power input (i.e., 41% less).

As used herein, the terms "about," "substantially," "essentially" and "approximately" when used in conjunction with ranges of dimensions, concentrations, temperatures or other physical or chemical properties or characteristics is meant to cover variations that may exist in the upper and/or lower limits of the ranges of the properties or characteristics, including, for example, variations resulting from rounding, measurement methodology or other statistical variation.

When introducing elements of the present disclosure or the embodiment(s) thereof, the articles "a", "an", "the" and "said" are intended to mean that there are one or more of the elements. The terms "comprising," "including," "containing" and "having" are intended to be inclusive and mean that there may be additional elements other than the listed elements. The use of terms indicating a particular orientation (e.g., "top", "bottom", "side", etc.) is for convenience of description and does not require any particular orientation of the item described.

As various changes could be made in the above constructions and methods without departing from the scope of the disclosure, it is intended that all matter contained in the above description and shown in the accompanying drawing[s] shall be interpreted as illustrative and not in a limiting sense.

The scope of the present invention is defined as set forth in the appended claims.

## Claims

1. An ingot puller apparatus for producing a silicon ingot comprising:
a crucible for holding a melt of silicon, the crucible having a floor and a sidewall that extends from the floor;
a growth chamber for pulling a silicon ingot from the melt along a pull axis;
a lift mechanism for raising and lowering the crucible during crystal growth relative to the pull axis, the crucible moving axially between a lowest position in which a charge of silicon is melted to produce the silicon melt, a seed-dip position at which a seed crystal is initially contacted with the melt to pull the silicon ingot from the melt, and a terminal position in which the crucible has been depleted of melt;
a side heater disposed radially outward to the crucible sidewall as the crucible travels from the lowest position to the terminal position;
a bottom heater disposed below the crucible floor; and
a heat shield disposed directly below the side heater, wherein a first portion of the heat shield is radially inward to the side heater and a second portion of the heat shield is radially outward to the side heater.

2. The ingot puller apparatus as set forth in claim 1 wherein the side heater is fully above the floor of the crucible when the crucible is in the lowest position.

3. The ingot puller apparatus as set forth in claim 1 or claim 2 wherein at least a portion of the heat shield is above a bottom of the crucible when the crucible is in the lowest position.

4. The ingot puller apparatus as set forth in any one of claims 1 to 3 wherein at least a portion of the heat shield is below at least a portion of the floor of the crucible when the crucible is in the lowest position.

5. The ingot puller apparatus as set forth in any one of claims 1 to 4 wherein the heat shield is fully below the floor of the crucible when the crucible is in the terminal position.

6. The ingot puller apparatus as set forth in any one of claims 1 to 5 wherein the heat shield has a length relative to the pull axis that is greater than a thickness of the heat shield.

7. The ingot puller apparatus as set forth in any one of claims 1 to 6 wherein the side heater and the heat shield are separated by a gap.

8. The ingot puller apparatus as set forth in any one of claims 1 to 7 wherein the side heater is separated from the heat shield by no more than 50 mm, no more than 40 mm, or wherein the side heater is not separated from the heat shield by a gap.

9. The ingot puller apparatus as set forth in any one of claims 1 to 8 wherein a distance between a bottom of the crucible and a bottom of the side heater is at least 25 mm when the crucible is in the lowest position.

10. The ingot puller apparatus as set forth in any one of claims 1 to 8 wherein the side heater has a thickness and the heat shield has a thickness, the thickness of the heat shield being at least 1.1 times the thickness of the side heater, at least 1.25 times the thickness of the side heater, at least 1.5 times the thickness of the side heater.

11. A method for preparing an ingot in an ingot puller apparatus according to any one of claims 1 to 10, the method comprising:
forming a melt of silicon in the crucible when the crucible is in a lowest position, the side heater being fully above the floor of the crucible when the crucible is in the lowest position;
contacting the melt with a seed crystal;
withdrawing an ingot from the silicon melt; and
raising the crucible as the ingot is withdrawn from the silicon melt, the crucible being in a terminal position when the ingot is separated from the melt.

12. The method as set forth in claim 11 wherein at least a portion of the heat shield is above a bottom of the crucible when the crucible is in the lowest position.

13. The method as set forth in claim 11 or claim 12 wherein at least a portion of the heat shield is below at least a portion of the floor of the crucible when the crucible is in the lowest position.

14. The method as set forth in any one of claims 11 to 13 wherein the heat shield is fully below the floor of the crucible when the crucible is raised to the terminal position.

## Patentansprüche

1. Eine Ingotziehvorrichtung zum Herstellen eines Siliziumingots, umfassend:
einen Tiegel zum Aufnehmen einer Siliziumschmelze, wobei der Tiegel einen Boden und eine Seitenwand aufweist, die sich vom Boden erstreckt;
eine Wachstumskammer zum Ziehen eines Siliziumingots aus der Schmelze entlang einer Ziehachse;
einen Hubmechanismus zum Anheben und Absenken des Tiegels während des Kristallwachstums relativ zur Ziehachse, wobei der Tiegel sich axial zwischen einer untersten Position, in der eine Siliziumcharge aufgeschmolzen wird, um die Siliziumschmelze zu erzeugen, einer Impftauchposition, in der ein Impfkristall anfangs mit der Schmelze in Kontakt gebracht wird, um den Siliziumingot aus der Schmelze zu ziehen, und einer Endposition, in der der Tiegel von Schmelze entleert ist, bewegt;
ein Seitenheizelement, das radial außerhalb der Tiegelseitenwand entlang des Verfahrwegs des Tiegels von der untersten Position bis zur Endposition angeordnet ist;
ein Bodenheizelement, das unterhalb des Tiegelbodens angeordnet ist; und
ein Hitzeschild, das unmittelbar unterhalb des Seitenheizelements angeordnet ist, wobei ein erster Abschnitt des Hitzeschilds radial innen relativ zum Seitenheizelement und ein zweiter Abschnitt radial außen relativ zum Seitenheizelement angeordnet ist.

2. Die Ingotziehvorrichtung nach Anspruch 1, wobei das Seitenheizelement vollständig oberhalb des Tiegelbodens angeordnet ist, wenn sich der Tiegel in der untersten Position befindet.

3. Die Ingotziehvorrichtung nach Anspruch 1 oder 2, wobei mindestens ein Abschnitt des Hitzeschilds oberhalb des Tiegelbodens angeordnet ist, wenn sich der Tiegel in der untersten Position befindet.

4. Die Ingotziehvorrichtung nach einem der Ansprüche 1 bis 3, wobei mindestens ein Abschnitt des Hitzeschilds unterhalb zumindest eines Abschnitts des Tiegelbodens angeordnet ist, wenn sich der Tiegel in der untersten Position befindet.

5. Die Ingotziehvorrichtung nach einem der Ansprüche 1 bis 4, wobei das Hitzeschild vollständig unterhalb des Tiegelbodens angeordnet ist, wenn sich der Tiegel in der Endposition befindet.

6. Die Ingotziehvorrichtung nach einem der Ansprüche 1 bis 5, wobei das Hitzeschild eine Länge entlang der Ziehachse aufweist, die größer ist als eine Dicke des Hitzeschilds.

7. Die Ingotziehvorrichtung nach einem der Ansprüche 1 bis 6, wobei das Seitenheizelement und das Hitzeschild durch einen Spalt voneinander getrennt sind.

8. Die Ingotziehvorrichtung nach einem der Ansprüche 1 bis 7, wobei das Seitenheizelement vom Hitzeschild um höchstens 50 mm oder um höchstens 40 mm getrennt ist, oder wobei das Seitenheizelement nicht durch einen Spalt vom Hitzeschild getrennt ist.

9. Die Ingotziehvorrichtung nach einem der Ansprüche 1 bis 8, wobei der Abstand zwischen dem Tiegelboden und dem unteren Ende des Seitenheizelements mindestens 25 mm beträgt, wenn sich der Tiegel in der untersten Position befindet.

10. Die Ingotziehvorrichtung nach einem der Ansprüche 1 bis 8, wobei das Seitenheizelement eine Dicke aufweist und das Hitzeschild eine Dicke aufweist, wobei die Dicke des Hitzeschilds mindestens das 1,1-Fache der Dicke des Seitenheizelements, mindestens das 1,25-Fache der Dicke des Seitenheizelements oder mindestens das 1,5-Fache der Dicke des Seitenheizelements beträgt.

11. Ein Verfahren zum Herstellen eines Ingots in einer Ingotziehvorrichtung nach einem der Ansprüche 1 bis 10, umfassend:
Bilden einer Siliziumschmelze im Tiegel, wenn sich der Tiegel in der untersten Position befindet, wobei das Seitenheizelement vollständig oberhalb des Tiegelbodens angeordnet ist, wenn sich der Tiegel in der untersten Position befindet;
Kontaktieren der Schmelze mit einem Impfkristall;
Herausziehen eines Ingots aus der Siliziumschmelze; und
Anheben des Tiegels, während der Ingot aus der Siliziumschmelze herausgezogen wird, wobei sich der Tiegel in einer Endposition befindet, wenn der Ingot von der Schmelze getrennt wird.

12. Das Verfahren nach Anspruch 11, wobei mindestens ein Abschnitt des Hitzeschilds oberhalb des Tiegelbodens angeordnet ist, wenn sich der Tiegel in der untersten Position befindet.

13. Das Verfahren nach Anspruch 11 oder Anspruch 12, wobei mindestens ein Abschnitt des Hitzeschilds unterhalb zumindest eines Abschnitts des Tiegelbodens angeordnet ist, wenn sich der Tiegel in der untersten Position befindet.

14. Das Verfahren nach einem der Ansprüche 11 bis 13, wobei das Hitzeschild vollständig unterhalb des Tiegelbodens angeordnet ist, wenn der Tiegel in die Endposition angehoben ist.

## Revendications

1. Appareil d'étirage de lingot pour produire un lingot de silicium comportant :
un creuset destiné à contenir un bain de silicium fondu, le creuset ayant un fond et une paroi latérale qui s'étend à partir du fond,
une chambre de croissance pour étirer un lingot de silicium à partir du bain fondu le long d'un axe d'étirage,
un mécanisme de levage pour faire monter et descendre le creuset pendant une croissance de cristal par rapport à l'axe d'étirage, le creuset se déplaçant axialement entre une position la plus basse dans laquelle une charge de silicium est fondue pour produire le bain de silicium fondu, une position d'immersion de germe dans laquelle un germe cristallin est initialement mis en contact avec le bain fondu pour étirer le lingot de silicium à partir du bain fondu, et une position terminale dans laquelle le bain fondu du creuset a été épuisé,
un dispositif de chauffage latéral disposé radialement vers l'extérieur par rapport à la paroi latérale de creuset lorsque le creuset se déplace de la position la plus basse à la position terminale,
un dispositif de chauffage inférieur disposé sous le fond de creuset, et
un écran thermique disposé directement sous le dispositif de chauffage latéral, dans lequel une première partie de l'écran thermique est radialement vers l'intérieur par rapport au dispositif de chauffage latéral et une seconde partie de l'écran thermique est radialement vers l'extérieur par rapport au dispositif de chauffage latéral.

2. Appareil d'étirage de lingot selon la revendication 1, dans lequel le dispositif de chauffage latéral est entièrement au-dessus du fond du creuset lorsque le creuset est dans la position la plus basse.

3. Appareil d'étirage de lingot selon la revendication 1 ou la revendication 2, dans lequel au moins une partie de l'écran thermique est au-dessus d'un fond du creuset lorsque le creuset est dans la position la plus basse.

4. Appareil d'étirage de lingot selon l'une quelconque des revendications 1 à 3, dans lequel au moins une partie de l'écran thermique est au-dessous d'au moins une partie du fond du creuset lorsque le creuset est dans la position la plus basse.

5. Appareil d'étirage de lingot selon l'une quelconque des revendications 1 à 4, dans lequel l'écran thermique est entièrement au-dessous du fond du creuset lorsque le creuset est dans la position terminale.

6. Appareil d'étirage de lingot selon l'une quelconque des revendications 1 à 5, dans lequel l'écran thermique a une longueur par rapport à l'axe d'étirage qui est supérieure à une épaisseur de l'écran thermique.

7. Appareil d'étirage de lingot selon l'une quelconque des revendications 1 à 6, dans lequel le dispositif de chauffage latéral et l'écran thermique sont séparés par un espace.

8. Appareil d'étirage de lingot selon l'une quelconque des revendications 1 à 7, dans lequel le dispositif de chauffage latéral est séparé de l'écran thermique par au plus 50 mm, au plus 40 mm, ou dans lequel le dispositif de chauffage latéral n'est pas séparé de l'écran thermique par un espace.

9. Appareil d'étirage de lingot selon l'une quelconque des revendications 1 à 8, dans lequel une distance entre un fond du creuset et un fond du dispositif de chauffage latéral est d'au moins 25 mm lorsque le creuset est dans la position la plus basse.

10. Appareil d'étirage de lingot selon l'une quelconque des revendications 1 à 8, dans lequel le dispositif de chauffage latéral présente une épaisseur et l'écran thermique présente une épaisseur, l'épaisseur de l'écran thermique étant égale à au moins 1,1 fois l'épaisseur du dispositif de chauffage latéral, au moins 1,25 fois l'épaisseur du dispositif de chauffage latéral, au moins 1,5 fois l'épaisseur du dispositif de chauffage latéral.

11. Procédé pour préparer un lingot dans un appareil d'étirage de lingot selon l'une quelconque des revendications 1 à 10, le procédé comportant de :
former un bain de silicium fondu dans le creuset lorsque le creuset est dans une position la plus basse, le dispositif de chauffage latéral étant entièrement au-dessus du fond du creuset lorsque le creuset est dans la position la plus basse,
mettre en contact le bain fondu avec un germe cristallin,
extraire un lingot à partir du bain de silicium fondu, et
faire monter le creuset lorsque le lingot est extrait du bain de silicium fondu, le creuset étant dans une position terminale lorsque le lingot est séparé du bain fondu.

12. Procédé selon la revendication 11, dans lequel au moins une partie de l'écran thermique est au-dessus d'un fond du creuset lorsque le creuset est dans la position la plus basse.

13. Procédé selon la revendication 11 ou la revendication 12, dans lequel au moins une partie de l'écran thermique est au-dessous d'au moins une partie du fond du creuset lorsque le creuset est dans la position la plus basse.

14. Procédé selon l'une quelconque des revendications 11 à 13, dans lequel l'écran thermique est entièrement au-dessous du fond du creuset lorsque le creuset est soulevé jusqu'à la position terminale.
